# EUROPEAN PATENT APPLICATION

(11) **EP 4 589 648 A1**
(43) Date of publication of application: **23.07.2025**
(21) Application number: 24195732.3
(22) Date of filing: 21.08.2024
(51) Int. Cl.: H01L 21/78

(54) **METHOD AND STRUCTURE FOR LASER SPLITTING**

(30) Priority: 22.01.2024 US 202418418966
(71) Applicant: II-VI Delaware, Inc., Wilmington, DE 19890 (US)
(72) Inventor: ZWIEBACK, Ilya, Wilmington, 19890 (US); CHEN, Young-Kai, Wilmington, 19890 (US); LEE, Dong, Wilmington, 19890 (US)
(74) Representative: Schmidt, Christian

(57) **Abstract**

A laser-splittable structures (for example, semiconductor wafers), methods for making a laser-splittable structure, systems for laser splitting a structure, and methods for laser splitting a structure. As non-limiting examples, various aspects of this disclosure provide laser-splittable semiconductor wafers, laser-splittable structures (for example, semiconductor wafers), methods for making a laser-splittable structure, systems for laser splitting a structure, and methods for laser splitting a structure, where the laser-splittable structure comprises a first layer characterized by a first laser ablation threshold, and a second layer characterized by a second laser ablation threshold that is less than the first laser ablation threshold.

## Description

### BACKGROUND

Present methods and structures for laser splitting a material structure are inadequate, for example resulting in excess material waste, higher product cost, greater manufacturing time, split layers that are too thick, etc. As a non-limiting example, present methods and structures for laser splitting a semiconductor wafer into thin layers result in greater material loss and cost than necessary. Further limitations and disadvantages of conventional and traditional approaches will become apparent to one of skill in the art, through comparison of such approaches with the present disclosure as set forth in the remainder of the present application with reference to the drawings.

### BRIEF DESCRIPTION OF SEVERAL VIEWS OF THE DRAWINGS

Figure 1 shows a cross-sectional view illustrating an example structure for laser splitting, in accordance with various aspects of the present disclosure.
Figure 2 shows a flow diagram illustrating an example method for forming a laser-splittable structure, in accordance with various aspects of the present disclosure.
Figure 3 shows cross-sectional views illustrating an example laser-splittable structure and an example method for forming a laser-splittable structure, in accordance with various aspects of the present disclosure.
Figure 4 shows cross-sectional views illustrating an example laser-splittable structure and an example method for forming a laser-splittable structure, in accordance with various aspects of the present disclosure.
Figure 5 shows cross-sectional views illustrating an example laser-splittable structure and an example method for forming a laser-splittable structure, in accordance with various aspects of the present disclosure.
Figure 6 shows cross-sectional views illustrating an example laser-splittable structure and an example method for forming a laser-splittable structure, in accordance with various aspects of the present disclosure.
Figure 7 shows cross-sectional views illustrating an example laser-splittable structure and an example method for forming a laser-splittable structure, in accordance with various aspects of the present disclosure.
Figure 8 shows cross-sectional views illustrating an example laser-splittable structure and an example method for forming a laser-splittable structure, in accordance with various aspects of the present disclosure.
Figure 9 shows a flow diagram illustrating an example method for laser splitting a structure, in accordance with various aspects of the present disclosure.
Figure 10 shows cross-sectional views illustrating an example system for laser splitting a structure, an example laser-splittable structure, and an example method for laser splitting a structure, in accordance with various aspects of the present disclosure.
Figure 11 shows cross-sectional views illustrating an example system for laser splitting a structure, an example laser-splittable structure, and an example method for laser splitting a structure, in accordance with various aspects of the present disclosure.

### SUMMARY

Various aspects of this disclosure provide laser-splittable structures (for example, semiconductor wafers), methods for making a laser-splittable structure, systems for laser splitting a structure, and methods for laser splitting a structure. As non-limiting examples, various aspects of this disclosure provide laser-splittable semiconductor wafers, laser-splittable structures (for example, semiconductor wafers), methods for making a laser-splittable structure, systems for laser splitting a structure, and methods for laser splitting a structure, where the laser-splittable structure comprises a first layer characterized by a first laser ablation threshold, and a second layer characterized by a second laser ablation threshold that is less than the first laser ablation threshold.

### DETAILED DESCRIPTION OF VARIOUS ASPECTS OF THE DISCLOSURE

The following discussion presents various aspects of the present disclosure by providing examples thereof. Such examples are non-limiting, and thus the scope of various aspects of the present disclosure should not necessarily be limited by any particular characteristics of the provided examples. In the following discussion, the phrases "for example," "e.g.," and "exemplary" are non-limiting and are generally synonymous with "by way of example and not limitation," "for example and not limitation," and the like.

As utilized herein, "and/or" means any one or more of the items in the list joined by "and/or". As an example, "x and/or y" means any element of the three-element set {(x), (y), (x, y)}. In other words, "x and/or y" means "one or both of x and y." As another example, "x, y, and/or z" means any element of the seven-element set {(x), (y), (z), (x, y), (x, z), (y, z), (x, y, z)}. In other words, "x, y and/or z" means "one or more of x, y, and z."

The terminology used herein is for the purpose of describing particular examples only and is not intended to be limiting of the disclosure. As used herein, the singular forms are intended to include the plural forms as well, unless the context clearly indicates otherwise. It will be further understood that the terms "comprises," "includes," "comprising," "including," "has," "have," "having," and the like when used in this specification, specify the presence of stated features, integers, steps, operations, elements, and/or components, but do not preclude the presence or addition of one or more other features, integers, steps, operations, elements, components, and/or groups thereof.

It will be understood that, although the terms first, second, etc. may be used herein to describe various elements, these elements should not be limited by these terms. These terms are only used to distinguish one element from another element. Thus, for example, a first element, a first component or a first section discussed below could be termed a second element, a second component or a second section without departing from the teachings of the present disclosure. Similarly, various spatial terms, such as "upper," "lower," "side," and the like, may be used in distinguishing one element from another element in a relative manner. It should be understood, however, that components may be oriented in different manners, for example a semiconductor device or package may be turned sideways so that its "top" surface is facing horizontally and its "side" surface is facing vertically, without departing from the teachings of the present disclosure.

In the drawings, the thickness or size of layers, regions, and/or components may be exaggerated for clarity. Accordingly, the scope of this disclosure should not be limited by such thickness or size. Additionally, in the drawings, like reference numerals may refer to like elements throughout the discussion. Elements numbered with an apostrophe (') can be similar to correspondingly numbered elements without an apostrophe.

It will also be understood that when an element A is referred to as being "connected to" or "coupled to" an element B, the element A can be directly connected to the element B or indirectly connected to the element B (*e.g.*, an intervening element C (and/or other elements) may be present between the element A and the element B).

Various aspects of this disclosure provide a laser-splittable structure (for example, a semiconductor wafer), a method for making a laser-splittable structure, a system for laser splitting a structure, and a method for laser splitting a structure, which can for example decrease the size, decrease the cost, decrease the waste, decrease energy utilization, increase the reliability, and/or improve the manufacturability of sliced structures, etc.

The above and other aspects of the present disclosure will be described in or be apparent from the following description of various example implementations. Various aspects of the present disclosure will now be presented with reference to accompanying drawings, such that those skilled in the art may readily practice the various aspects.

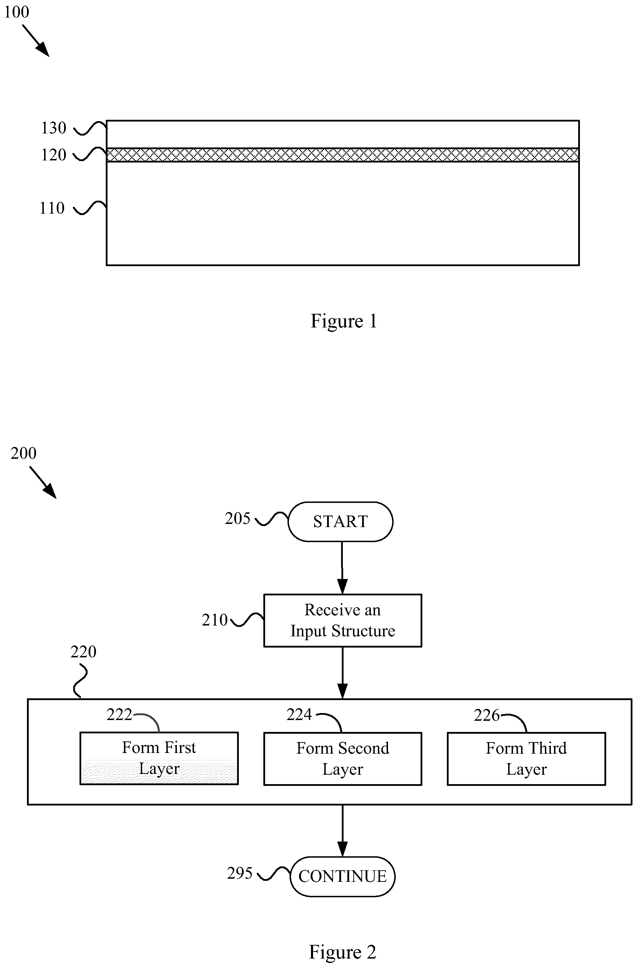

Turning first to Figure 1, such figure shows a cross-sectional view illustrating an example structure for laser splitting, in accordance with various aspects of the present disclosure.

The example structure 100, which may also be referred to herein as a material structure or splittable structure, may comprise any of a variety of characteristics, non-limiting examples of which are provided herein. The structure 100 may, for example, comprise characteristics to enhance a laser splitting function to be performed on the structure 100.

The example structure 100 may, for example, comprise a semiconductor ingot (or structure or material), for example to be split or sliced into wafers for semiconductor circuit production, but the scope of this disclosure is not limited to semiconductor material. The structure 100, for example any or all of the layers thereof, may comprise a glass material, a ceramic material, a crystal material, a metal material, etc.

The example structure 100 may, for example, comprise a first layer 110, a second layer 120, and a third layer 130. Note that the example structure 100 may comprise any number of layers, for example, any combination or sequence of the example layers 110, 120, and 130. For example, on the first layer 110, an example structure may comprise any number of alternating second layers 120 and third layers 130.

The example first layer 110 may, for example, comprise a relatively low grade semiconductor material, for example of a quality used as a foundation (or base or carrier) during semiconductor circuitry production. The first layer 110, however, is not limited to any particular type of material. For example, the first layer 110 may comprise a mid-grade or high-grade semiconductor material, a glass material, a ceramic material, a crystal material, etc.

The first layer 110 may, for example be characterized by a first laser ablation threshold. The first laser ablation threshold may, for example, be associated with a first level of laser energy at which the first material of the first layer 110 breaks down. The first laser ablation threshold may, for example, be associated with a minimum level of laser energy at which an ablation process occurs in the first material of the first layer 110. For example, the first layer 110 may be characterized by a first optical transmittance, a first optical absorbance, a first optical opacity, a first optical transparency, etc. Such parameters may, for example, depend on the material, for example the strength of the chemical bonds, the ability of the material to absorb laser light, etc.

The first layer 110 may, for example, be characterized by a first bandgap. For example, for a semiconductor material, the stronger the crystal bonds are, the wider the bandgap is, and the higher the laser ablation threshold is.

The first layer 110 may be characterized by any of a variety of first thicknesses. For example, the first thickness of the first layer 110 may be up to 100 microns thick (or at least 100 microns thick), up to 500 microns thick (or at least 500 microns thick), up to 800 microns thick (or at least 800 microns thick), up to 1000 microns thick (or at least 1000 microns thick), a thickness in any range between such amounts, etc.

The example second layer 120 may, for example, comprise a relatively low grade semiconductor, for example of a quality used as a sacrificial layer during semiconductor circuitry production. The second layer 120, however, is not limited to any particular type of material. For example, the second layer 120 may comprise a mid-grade or high-grade semiconductor material, a glass material, a ceramic material, a crystal material, etc.

The second layer 120 may, for example, be characterized by a second laser ablation threshold. The second laser ablation threshold may, for example, be associated with a second level of laser energy at which the second material of the second layer 120 breaks down. The second laser ablation threshold may, for example, be associated with a second level of laser energy at which an ablation process occurs in the second material of the second layer 120. In an example configuration, the second laser ablation threshold may be lower than the first laser ablation threshold of the first layer 110.

For example, the second layer 120 may be characterized by a second optical transmittance (e.g., less than the first optical transmittance, etc.), a second optical absorbance (e.g., greater than the first optical absorbance, etc.), a second optical opacity (e.g., greater than the first optical opacity, etc.), a second optical transparency (e.g., less than the first optical transparency, etc.), etc. The second layer 120 may, for example, be characterized by a second bandgap (e.g., narrower than the first bandgap, etc.).

As will be discussed in more detail here, in an example implementation, the second material of the second layer 120 may comprise the first material of the first layer 110, albeit with a second doping level that is higher than a first doping level of the first material. Such a relatively higher second doping level may, for example, result in the second optical absorbance being greater than the first optical absorbance, and the second laser ablation threshold being lower than the first laser ablation threshold.

In an example implementation, the first material of the first layer 110 may comprise a low-nitrogen-doped n-type silicon carbide (SiC), and the second material of the second layer 120 may comprise a low-nitrogen-doped n-type silicon carbide (SiC) which has been heavily doped with carbon.

In an example implementation, the first material of the first layer 110 may comprise a low-doped gallium arsenide (GaAs), and the second material of the second layer 120 may comprise heavily-doped gallium arsenide (GaAs). For example, the second material (e.g., GaAs, etc.) of the second layer 120 may be doped with an element of the VI group (e.g., selenium, etc.) to at least 5x 10¹⁷ cm³, at least 10¹⁸ cm³, to at least 5x 10¹⁸ cm³, to at least 10¹⁹ cm³, to any range between such levels, etc. The second material of the second layer 120 may, for example, be doped to a level that is at least an order of magnitude higher (or two orders of magnitude higher, or three orders of magnitude higher, etc.) than a doping level of the first material of the first layer 110.

Also, as will be discussed in more detail herein, in an example implementation, the second material of the second layer 120 may comprise a substantially different material than the first material of the first layer 110. For example, such first and second materials may be selected such that the second bandgap of the second material is narrower than the first bandgap of the first material. Such a narrower second bandgap may, for example, result in the second laser ablation threshold being less than the first laser ablation threshold. Note that in such an example implementation, the second material of the second layer 120 may be lattice-matched to the first material of the first layer 110 (e.g., lattice-matched to within 5%, to within 7.5%, to within 10%, etc.). The second material of the second layer 120 may, for example, have a second bandgap that is at least an order of magnitude lower (or two orders of magnitude lower, or three orders of magnitude lower, etc.) than a first bandgap of the first material of the first layer 110.

In an example implementation involving III-IV compounds, the first material of the first layer 110 may comprise gallium arsenide (GaAs), and the second material of the second layer 120 may comprise indium arsenide (InAs). The lattice mismatch between the InAs and the GaAs may, for example, be about 7.2%.

The second layer 120 may be characterized by any of a variety of second thicknesses. For example, the second thickness of the second layer 120 may be up to 0.5 microns thick, up to 1 micron thick, up to 2 microns thick, in a range of 0.5-2.0 microns thick, up to 5 microns thick, up to 10 microns thick, a thickness in any range between such amounts, etc.

Note that the second layer 120 may, for example, be continuous and consistent throughout. The second layer 120 may also, for example, have a 2D or 3D matrix shape.

The example third layer 130 may, for example, comprise a relatively high grade semiconductor, for example of a quality used as a circuit layer during semiconductor circuitry production. For example, in an example implementation, before laser-splitting is performed, the third layer 130 may comprise semiconductor circuitry formed thereon. Note that the presence of such circuitry is not required. The third layer 130, however, is not limited to any particular type of material. For example, the third layer 130 may comprise a mid-grade or low-grade semiconductor material, a glass material, a ceramic material, a crystal material, a metal material, etc.

The third layer 130 may, for example, be characterized by a third laser ablation threshold. The third laser ablation threshold may, for example, be associated with a third level of laser energy at which the third material of the third layer 130 breaks down. The third laser ablation threshold may, for example, be associated with a third level of laser energy at which an ablation process occurs in the third material of the third layer 130. In an example configuration, the third laser ablation threshold may be higher than the second laser ablation threshold of the second layer 120. In an example configuration, the third laser ablation threshold may be the same as (or substantially the same as) the first laser ablation threshold of the first layer 110.

The third layer 130 may, for example, be characterized by a third optical transmittance (e.g., greater than the second optical transmittance, etc.), a third optical absorbance (e.g., less than the second optical absorbance, etc.), a third optical opacity (e.g., less than the second optical opacity, etc.), a third optical transparency (e.g., greater than the second optical transparency, etc.), etc. The third layer 130 may, for example, be characterized by a third bandgap (e.g., wider than the second bandgap, etc.).

As will be discussed in more detail here, in an example implementation, the third material of the third layer 130 may comprise the second material of the second layer 120, albeit with a third doping level that is lower than the second doping level of the second material. Such a relatively lower third doping level may, for example, result in the third optical absorbance being less than the second optical absorbance, and the third laser ablation threshold being higher than the second laser ablation threshold.

In an example implementation, the first material of the first layer 110 may comprise a low-nitrogen-doped n-type silicon carbide (SiC), the second material of the second layer 120 may comprise a low-nitrogen-doped n-type silicon carbide (SiC) which has been heavily doped with carbon, and the third material of the third layer 130 may comprise a low-nitrogen-doped (or mid-nitrogen-doped) n-type silicon carbide (SiC). Note that in this example, the first doping level and the third doping level may be the same, but may also differ. For example, the third doping level may be greater than the first doping level and less than the second doping level.

In an example implementation, the first material of the first layer 110 may comprise a low-doped gallium arsenide (GaAs), the second material of the second layer 120 may comprise heavily-doped gallium arsenide (GaAs), and the third material of the third layer 130 may comprise low-doped (or mid-doped) gallium arsenide (GaAs). For example, the second material (e.g., GaAs, etc.) of the second layer 120 may be doped with an element of the VI group (e.g., selenium, etc.) to at least 5x 10¹⁷ cm³, to at least 10¹⁸ cm³, to at least 5x 10¹⁸ cm³, to at least 10¹⁹ cm³, to any range between such levels, etc. Note that in this example, the first doping level and the third doping level may be the same (or substantially the same) or may differ. For example, the third doping level may be greater than the first doping level and less than the second doping level.

In an example implementation, the third material of the third layer 130 and the first material of the first layer 110 may correspond to similar or same materials, albeit having different respective quality levels. For example, the first material of the first layer 110 may correspond to a relatively low-quality material (e.g., a semiconductor material, a glass material, a ceramic material, a crystal material, etc.), and the third material of the third layer 130 may correspond to a relatively high-quality material (e.g., a semiconductor material, a glass material, a ceramic material, a crystal material, etc.). In such cases, the quality levels might reflect purity levels, crystal consistency, etc.

Also, as will be discussed in more detail herein, in an example implementation, the third material of the third layer 130 may comprise a substantially different material than the second material of the second layer 120 and/or the first material of the first layer 110. For example, such third and second materials may be selected such that the third bandgap of the third material is wider than the second bandgap of the second material. Such a wider third bandgap may, for example, result in the third laser ablation threshold being greater than the second laser ablation threshold. Note that in such an example implementation, the third material of the third layer 130 may be lattice-matched to the second material of the second layer 120 (e.g., lattice-matched to within 5%, to within 7.5%, to within 10%, etc.).

In an example implementation involving III-IV compounds, the first material of the first layer 110 may comprise gallium arsenide (GaAs), the second material of the second layer 120 may comprise indium arsenide (InAs), and the third material of the third layer 130 may comprise gallium arsenide (GaAs) (e.g., a low-doped GaAs layer, etc.). The lattice mismatch between the InAs and the GaAs may, for example, be about 7.2%. Note that the third material of the third layer 130 need not be the same as the first material of the first layer 110.

The third layer 130 may be characterized by any of a variety of third thicknesses. For example, the third thickness of the third layer 130 may be up to 1 micron thick, may be up to 2 microns thick, may be up to 5 microns thick, may be up to 10 microns thick, may be in a range of 10-20 microns thick, may be up to 25 microns thick, may be a thickness in any range between such amounts, etc.

Figure 1 shows a cross-sectional view illustrating an example structure for laser splitting, in accordance with various aspects of the present disclosure. Accordingly, the scope of this disclosure should not be limited by specific characteristics of the example structure.

Figure 2 shows a flow diagram illustrating an example method for forming a laser-splittable structure, in accordance with various aspects of the present disclosure. The example method 200, for example any of the structures or layers formed thereby, may share any or all characteristics with the example structure 100 and/or layers 110, 120, and 130 discussed herein. Note that the scope of this disclosure is not limited to any particular order of the method blocks (or steps) discussed herein.

The laser-splittable structure may, for example, comprise a first layer characterized by a first laser ablation threshold, a second layer characterized by a second laser ablation threshold, and a third layer characterized by a third laser ablation threshold. Note, however, that the laser-splittable structure may have any number of layers.

The example method 200 may begin executing at block 205. The method 200 may begin executing in response to any of a variety of causes or conditions, non-limiting examples of which are provided herein. For example, the method 200 may begin executing automatically in response to one or more signals received from one or more upstream and/or downstream manufacturing stations, in response to a signal from a central manufacturing line controller, etc. Also for example, the method 200 may begin executing in response to an operator command to begin.

The example method 200 may, at block 210, comprise receiving an input structure. Block 210 may comprise receiving the input structure in any of a variety of manners, non-limiting aspects of which are provided herein.

For example, block 210 may comprise receiving the input structure from an upstream manufacturing process at a same premises, same campus, same site, etc. Also for example, block 210 may comprise receiving the input structure from a shipping process. Note that the example method 200 may comprise forming the input structure, for example prior to block 210, as a portion or all of block 210, etc.

The input structure received at block 210 may comprise any of a variety of characteristics. For example, the received input structure may share any or all characteristics with the structure 100 shown and discussed herein with regard to Figure 1.

Also for example, the received input structure may share any or all characteristics with the first layer 110, second layer 120, and/or third layer 130 shown and discussed herein with regard to Figure 1. For example, the received input structure may comprise at least a portion of material for the first layer 110. Also for example, the received input structure may comprise at least a portion of material for the first layer 110 and for the second layer 120. Additionally for example, the received input structure may comprise at least a portion of material for the first layer 110, for the second layer 120, and for the third layer 130.

In general, block 210 may comprise receiving an input structure. Accordingly, the scope of this disclosure should not be limited by characteristics of any particular manner of receiving an input structure or by characteristics of any particular input structure.

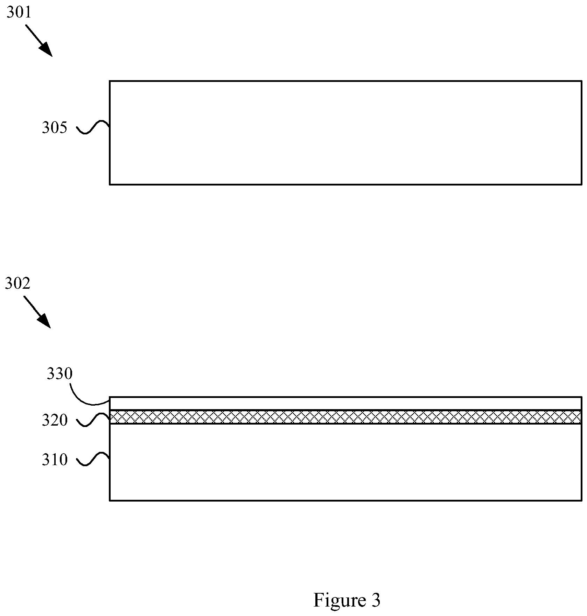

The example method 200 may, at block 220, comprise forming a laser-splittable structure. Block 220 may comprise forming a laser-splittable structure in any of a variety of manners, many non-limiting examples of which are provided herein, for example by Figures 3-8 and the discussions thereof.

The formed laser-splittable structure may, for example, comprise a first layer characterized by a first laser ablation threshold, a second layer characterized by a second laser ablation threshold, and/or a third layer characterized by a third laser ablation threshold. The laser-splittable structure formed at block 220 may, for example, share any or all characteristics with the laser-splittable structure 100 shown in Figure 1 and discussed herein. For example, a formed first layer may share any or all characteristics with the first layer 110 of Figure 1, a formed second layer may share any or all characteristics with the second layer 120 of Figure 1, and/or a formed third layer may share any or all characteristics with the third layer 130 of Figure 1.

Block 220 may, for example, comprise forming a first layer (or a portion thereof) at block 222, forming a second layer (or a portion thereof) at block 224, and/or forming a third layer (or a portion thereof) at block 226 (or respective portions thereof) simultaneously and/or sequentially. Various examples of such forming are provided herein.

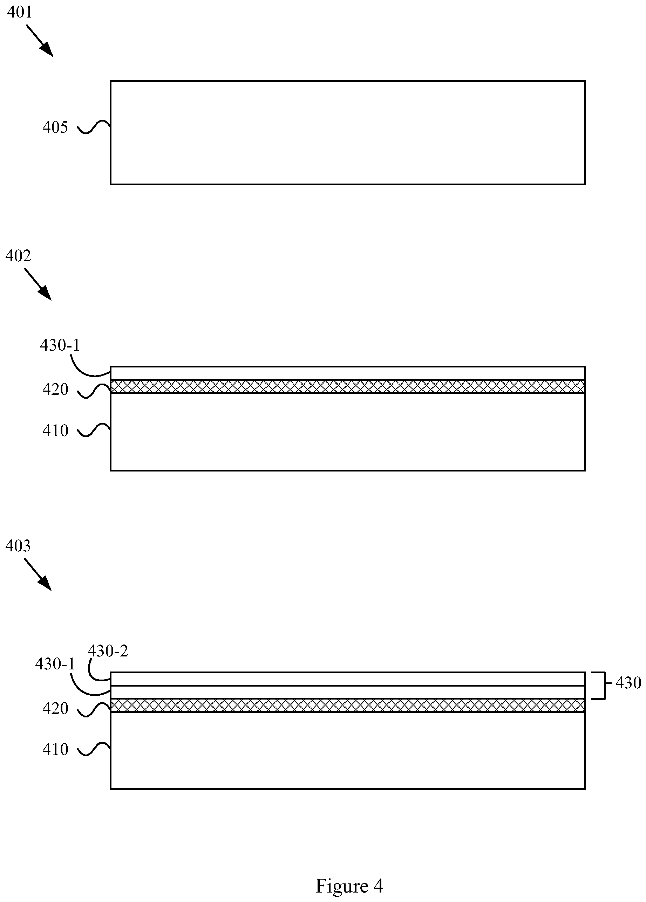

For example, block 220 may comprise forming at least a second layer by, at least in part, utilizing ion implantation to form the at least a second layer. Such ion implantation may, for example, be performed on the input structure received at block 210. For example, block 220 may comprise utilizing ion implantation to form at least a second layer by increasing the optical absorption of a portion of the input structure received at block 210. Such ion implantation may also, for example, form or define at least respective portions of a first layer and/or a third layer. Non-limiting examples of such ion implantation are provided here, for example by Figure 3 and the discussion thereof. Additional non-limiting examples of such ion implantation may be provided by Figures 4 and 6-8, and the discussions thereof, etc.

Also for example, block 220 may comprise forming at least a second layer by, at least in part, growing the at least a second layer. For example, such growing may be performed on (e.g., directly on, etc.) the input structure received at block 210. For example, block 220 may comprise growing the second layer to have a higher level of doping than the input structure (e.g., utilizing homo-epitaxial growth, etc.). In such an example implementation, the input structure may thus be considered a first layer. Also for example, block 220 may comprise growing the second layer (e.g., utilizing hetero-epitaxial growth, etc.) on (e.g., directly on, etc.) the input structure to have a narrower bandgap than the input structure. In such an example implementation, the input structure may thus be considered a first layer.

Additionally for example, block 220 may comprise bonding a second layer to the first layer, for example utilizing any of a variety of bonding techniques.

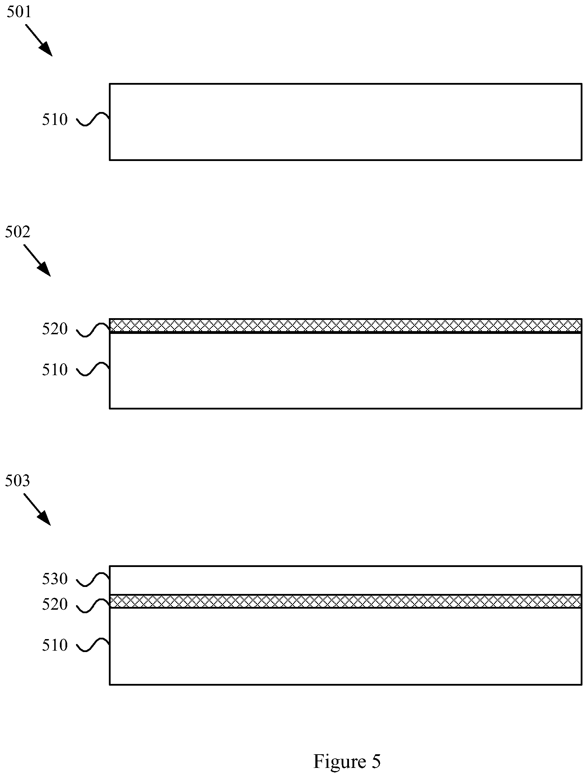

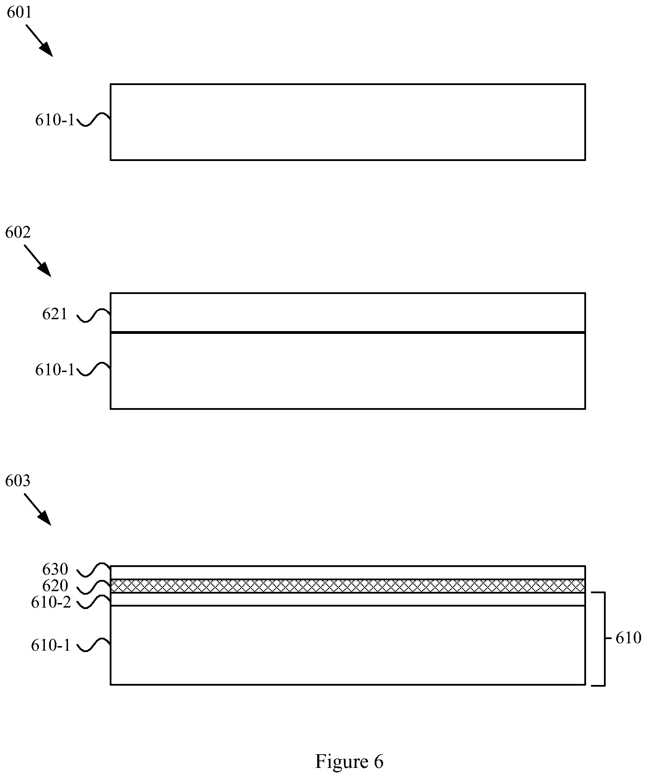

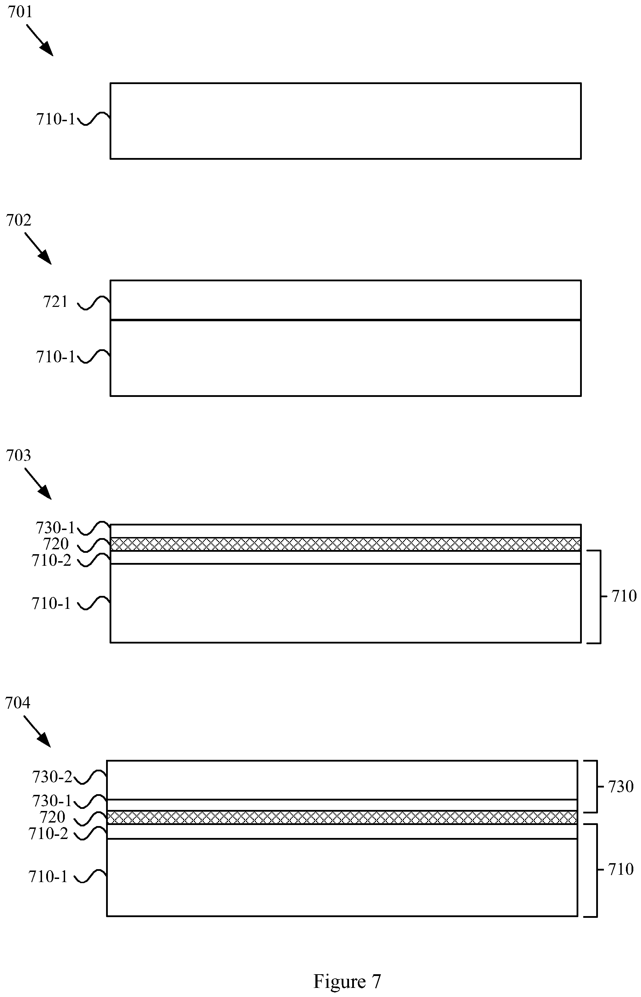

Block 220 may, for example, comprise growing at least a portion of a third layer. Non-limiting examples of such growing are provided herein, for example by Figure 5 and the discussion thereof. Additional non-limiting examples of such growing may be provided by Figures 6 and 7, and the discussions thereof, etc.

In general, block 220 may comprise forming a laser-splittable structure. Accordingly, the scope of this disclosure should not be limited by characteristics of any particular manner of forming a laser-splittable structure.

The example method 200 may, at block 295, comprise performing continued processing. Block 295 may comprise performing any of a variety of types of continued processing. For example, block 295 may comprise directing execution flow of the example method 200 back to any block thereof, any portion of a block thereof, etc. For example, one or more additional layers may be formed.

Also for example, block 295 may comprise forming circuitry on or in any of the layers discussed herein. Block 295 may, for example, comprise cleaning and/or shipping a structure resulting from any of the blocks of the example method 200.

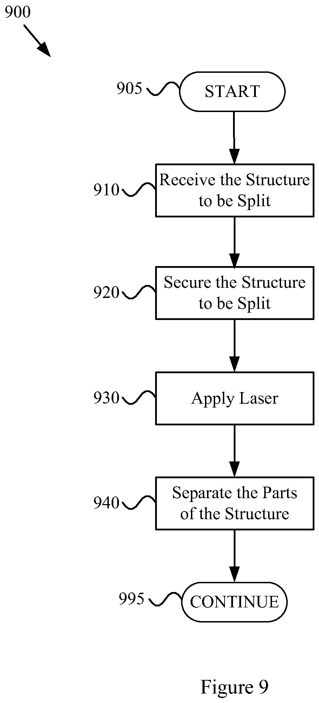

As provided by example by Figures 9-11 and the discussions thereof, block 295 may comprise splitting and/or dicing the structure resulting from any of the blocks of the example method 200.

In general block 295 may comprise performing continued processing. Accordingly, the scope of this disclosure should not be limited by characteristics of any particular amount or type of continued processing.

As mentioned herein, many example implementations of the example method 200 of Figure 2 are provided herein. Figures 3-8, and the discussions thereof, will provide many of such example implementations.

Figure 3 shows cross-sectional views illustrating an example laser-splittable structure and an example method for forming a laser-splittable structure, in accordance with various aspects of the present disclosure. Figure 3 and the example methods and structures shown therein will be discussed in conjunction with the flow diagram 200 of Figure 2.

Block 210 may comprise receiving an input structure. The example input structure 301 of Figure 3 provides an example of such a received input structure. Although the example input structure 301 is shown as having only one layer 305, the input structure 301 may comprise any number of layers. The received input structure 301 may, for example, share any or all characteristics with the example structure 100 of Figure 1 or any portion thereof.

Block 220 may comprise forming a laser-splittable structure. The example laser-splittable structure 302 may, for example, share any or all characteristics with the example laser-splittable structure 100 of Figure 1 or any portion thereof. For example, the first layer 310 may share any or all characteristics with the first layer 110 of Figure 1, the second layer 320 may share any or all characteristics with the second layer 120 of Figure 1, and/or the third layer 330 may share any or all characteristics with the third layer 130 of Figure 1.

As discussed herein, block 220 may comprise utilizing ion implantation to form at least a second layer 320. For example, ion implantation may be performed at or about a depth of 1-2 microns from the upper surface of the layer 305 of the input structure 301 to form the second layer 320 as a heavily doped layer of about 1 micron thick. For example, the heavily doped layer may be doped to about 10¹⁸ cm⁻³. Also for example, the heavily doped layer may be doped to about 5×10¹⁸ cm⁻³ or 10¹⁹ cm⁻³. Such doping levels may, for example, depend on the characteristics of the material, the types of ions, the ionization energy level, etc. Such a heavily doped second layer 320 may, for example, have a higher absorption property (e.g., have a lower ablation threshold) than non-doped or lower-doped material (e.g., material of the first layer 310 and/or third layer 330, etc.).

Note that while this example shows forming the heavily doped layer 320 below the top surface of the layer 305 of the input structure 301, for example below the third layer 330, the heavily doped layer 320 may also be formed at the top surface of the layer 305 of the input structure 301. In such an implementation, the third layer 330 may be added by a later process.

Block 220 may comprise forming the heavily doped second layer 320 at various depths below the top surface of the layer 305 of the input structure 301. For example, in an example implementation, silicon, phosphorous, and/or boron ions may be utilized to form the heavily doped second layer 320 at (or about at) a depth of 3 microns. Also for example, in an example implementation, helium or hydrogen ions may be utilized to form the heavily doped second layer 320 at (or about at) a depth of 10 microns or more.

In an example implementation, the received input structure 301 (and thus the resulting first layer 310 and third layer 330) may comprise silicon carbide (SiC). The second layer 320 may then, for example, be formed by implanting ions of nitrogen, phosphorus, and/or aluminum. Ions of carbon, silicon, boron, various metallic elements, and/or hydrogen may also be implanted. For example, in an example implementation, the layer 305 of the input structure 301 (e.g., an entirety thereof, an upper part thereof, etc.) may comprise a low-nitrogen-doped n-type SiC, while the heavily doped layer 320 is heavily doped utilizing ion implantation of carbon with the carbon concentration peaking at or about 10¹⁸ cm⁻³.

Note that ion implantation may cause amorphization of the top surface and subsurface areas. Thus, ion implantation may, for example, be carried out at an elevated temperature and/or be followed by annealing or post-implantation.

In the example implementation shown in Figure 3, ion implantation is performed on the layer 305 of the input structure 301 to form the second layer 320 within the layer 305 of the input structure 301, resulting in a three layer structure comprising the first layer 310, the second layer 320, and the third layer 330.

In various example implementations, it may be desirable to have a third layer 330 that is thicker than that resulting from the ion implantation process. As discussed herein, block 220 of the example method may comprise growing (or otherwise adding) material, for example a portion of a layer, an entirety of a layer, a plurality of layers, etc. Figure 4 provides examples of methods and structures similar to those of Figure 3, but with an additional material growing step.

Figure 4 shows cross-sectional views illustrating an example laser-splittable structure and an example method for forming a laser-splittable structure, in accordance with various aspects of the present disclosure. Figure 4 and the example methods and structures shown therein will be discussed in conjunction with the flow diagram 200 of Figure 2.

Block 210 may comprise receiving an input structure. The example input structure 401 of Figure 4 provides an example of such a received input structure. Although the example input structure 401 is shown as having only one layer 405, the input structure 401 may comprise any number of layers. The received input structure 401 may, for example, share any or all characteristics with the example structure 100 of Figure 1 or any portion thereof. Also for example, the received input structure 401 and layer 405 thereof may share any or all characteristics with the example input structure 301 and layer 305 of Figure 3, etc.

Block 220 may comprise forming a laser-splittable structure. For example, block 220 may comprise forming an intermediate structure 402 and a laser-splittable structure 403.

The example intermediate structure 402 shown in Figure 4 may, for example, share any or all characteristics with the example laser-splittable structures 100 and 302 of Figures 1 and 3, or any portion thereof. For example, the first layer 410 may share any or all characteristics with the first layers 110 and 310 of Figures 1 and 3, the second layer 420 may share any or all characteristics with the second layers 120 and 320 of Figures 1 and 3, and/or the first portion 430-1 of the third layer 430 may share any or all characteristics with the third layers 130 and 330 of Figures 1 and 3. Note that the intermediate structure 402 may itself be laser-splittable, for example as discussed herein with regard to the laser-splittable structure 302 of Figure 3.

The example laser-splittable structure 403 shown in Figure 4 may, for example, share any or all characteristics with the example laser-splittable structures 100 and 302 of Figures 1 and 3, or any portion thereof. For example, the first layer 410 may share any or all characteristics with the first layers 110 and 310 of Figures 1 and 3, the second layer 420 may share any or all characteristics with the second layers 120 and 320 of Figures 1 and 3, and/or the third layer 430 (e.g., comprising the first portion 430-1 and/or the second portion 430-2) may share any or all characteristics with the third layers 130 and 330 of Figures 1 and 3.

Block 220 may comprise forming the intermediate structure 402 in any of a variety of manners. For example, block 220 may comprise forming the intermediate structure 402 in a same or similar manner to that discussed with regard to the forming of the laser-splittable structure 302 of Figure 3.

Block 220 may comprise forming the laser-splittable structure 403 in any of a variety of manners. For example, block 220 may comprising growing (or otherwise forming) the second portion 430-2 of the third layer 430 on (e.g., directly on, etc.) the first portion 430-1 of the third layer 430. The second portion 430-2 may also be referred to herein as an epilayer.

For example, block 220 may comprise growing the second portion 430-2 of the third layer 430 utilizing a crystal growth process, for example an epitaxial growth process (e.g., a homo-epitaxial growth process, a hetero-epitaxy growth process, etc.). For example, such growing may comprise condensing and/or solidifying gas or liquid. Block 220 may, for example, comprise utilizing a Czochralski (CZ) method, a float-zone crystal growth technique, etc. Many examples of such growing may, for example, be found in the semiconductor industry.

Note, however, that this disclosure extends beyond semiconductor technology, for example to glass technology, ceramic technology, crystal technology, etc. In such examples, block 220 may comprise growing (or forming) the second portion 430-2 of the third layer 430 utilizing a glass, ceramic, crystal, or other material deposition process.

In an example scenario, the thickness of the first portion 430-1 of the third layer 430 may be up to 1 micron thick, from 1 to 2 microns thick, from 1 to 5 microns thick, from 1 to 10 microns thick, etc. In such an example scenario, block 220 may comprise forming the second portion 430-2 of the third layer 430 to have a thickness from 10-20 microns thick, from 5 to 50 microns thick, from 1 to 100 microns thick, etc. Note that such thicknesses, and all thicknesses mentioned herein, are non-limiting examples.

The first portion 430-1 of the third layer 430 and the second portion 430-2 of the third layer 430 may, for example, comprise a same (or substantially same) material. For example, in an example scenario, the first portion 430-1 may comprise a relatively low-grade (e.g., low-cost, low-quality, low-purity, etc.) semiconductor material, and the second portion 430-2 may comprise a relatively high-grade (e.g., high-cost, high-quality, high-purity, etc.) semiconductor material that is the same general type as the semiconductor material of the first portion 430-1.

The semiconductor material of the first portion 430-1 of the third layer 430 and the second semiconductor material of the second portion 430-2 of the third layer 430 may be different types of semiconductor materials. For example, in such a scenario, the first portion 430-1 and the second portion 430-2 may be different types of semiconductor materials, but lattice-matched (e.g., lattice-matched to within 7.5%, lattice-matched to within 10%, etc.).

In an example implementation, the layer 405 of the input structure 401 received (or prepared) at block 210 may comprise a n-type SiC substrate, nitrogen-doped at 5 × 10¹⁸ cm⁻³, and be 350-500 microns thick. Block 220 may comprise forming the second layer 420 to be 1-1.5 microns thick, and to be positioned 2 microns (or about 2 microns) under the top surface of the layer 405 of the input structure 401. Block 220 may, for example, comprise forming such a second layer 420 by, at least in part, performing ion implantation of 100 keV carbon ions, for example carried out at a temperature of 600 degrees C. The carbon concentration in the second layer 420 may, for example, peak at about 10¹⁸ cm⁻³. Such a second layer 420 may, for example, have a relatively high optical absorption (or low laser ablation threshold) to the irradiation of an Nd:YAG laser with a wavelength of 1.064 microns when compared to the respective optical absorptions of the first layer 410 and the third layer 430. The first layer 410 and the first portion 430-1 of the third layer 430 may retain the characteristics of the input structure.

Continuing the example implementation, block 220 may then comprise growing the second portion 430-2 of the third layer 430 on the first portion 430-1 of the third layer 430. For example, block 220 may comprise growing the second portion 430-2 of the third layer 430 as a low-nitrogen-doped, n-type SiC epilayer. The thickness of such epilayer and the doping level may be tuned to match the requirements of a particular device being formed. For example, for a power switching device (e.g., a MOSFET, HEMT, etc.), the SiC epilayer may be formed to be 10-20 microns thick and nitrogen-doped to about 10¹⁵ cm⁻³. A desired device structure (e.g., a MOSFET structure, a HEMT structure, etc.) may then be formed on the epilayer utilizing various SiC device processing steps.

As discussed herein, for example in the discussion of block 220, the second layer may be formed at least in part by growing at least the second layer. Figure 5 provides examples of methods and structures that comprise growing (or otherwise forming) the second layer.

Figure 5 shows cross-sectional views illustrating an example laser-splittable structure and an example method for forming a laser-splittable structure, in accordance with various aspects of the present disclosure. Figure 5 and the example methods and structures shown therein will be discussed in conjunction with the flow diagram 200 of Figure 2.

Block 210 may comprise receiving an input structure. The example input structure 501 of Figure 5 provides an example of such a received input structure. Although the example input structure 501 is shown as having only one layer 510, the input structure 501 may comprise any number of layers. The received input structure 501 may, for example, share any or all characteristics with the example structure 100 of Figure 1 or any portion thereof. Also for example, the received input structure 501 and layer 510 thereof may share any or all characteristics with the example input structure 301 and layer 305 of Figure 3, with the example input structure 401 and layer 405 of Figure 4, etc.

Block 220 may comprise forming a laser-splittable structure. For example, block 220 may comprise forming an intermediate structure 502 and a laser-splittable structure 503.

The example intermediate structure 502 shown in Figure 5 may, for example, share any or all characteristics with the example structures 100, 302, and 402 of Figures 1, 3, and 4, or any portion thereof. For example, the first layer 510 may share any or all characteristics with the first layers 110, 310, and 410 of Figures 1, 3, and 4, and the second layer 520 may share any or all characteristics with the second layers 120, 320, and 420 of Figures 1, 3, and 4.

The example laser-splittable structure 503 shown in Figure 5 may, for example, share any or all characteristics with the example structures 100, 302, 402, and 403 of Figures 1, 3, and 4, or any portion thereof. For example, the first layer 510 may share any or all characteristics with the first layers 110, 310, and 410 of Figures 1, 3, and 4, the second layer 520 may share any or all characteristics with the second layers 120, 320, and 420 of Figures 1, 3, and 4, and/or the third layer 530 may share any or all characteristics with the third layers 130, 330, and 430 of Figures 1, 3, and 4.

Block 220 may comprise forming the intermediate structure 502 in any of a variety of manners. For example, block 220 may comprise forming the intermediate structure 502 in a same or similar manner to that discussed with regard to the forming of the second portion 430-2 of the third layer 430 of Figure 4, etc.

For example, block 220 (e.g., at block 224) may comprising growing (or otherwise forming) the second layer 520 on (e.g., directly on, etc.) the layer 510, which may be also be referred to herein as the first layer 510.

For example, block 224 may comprise growing the second layer 520 utilizing a crystal growth process, for example an epitaxial growth process (e.g., a homo-epitaxial growth process, a hetero-epitaxial growth process, etc.). For example, such growing may comprise condensing and/or solidifying gas or liquid. Block 224 may, for example, comprise utilizing a Czochralski (CZ) method, a float-zone crystal growth technique, etc. Many examples of such growing may, for example, be found in the semiconductor industry. Note, however, that this disclosure extends beyond semiconductor technology, for example to glass technology, ceramic technology, crystal technology, etc. In such examples, block 224 may comprise growing (or forming) the second layer 520 utilizing a glass, ceramic, crystal, or other material deposition process.

In an example scenario, the thickness of the second layer 520 may be up to 1 micron thick, from 1 to 2 microns thick, from 1 to 5 microns thick, etc. Note that such thicknesses, and all thicknesses mentioned herein, are non-limiting examples.

The first layer 510 and the second layer 520 may, for example, comprise a same (or substantially same) material. For example, the second layer 520 may comprise same semiconductor material as the first layer 510, albeit more heavily doped. As discussed herein, for example with regard to the second layer 120 of Figure 1, the second material of the second layer 520 may comprise the first material of the first layer 510, albeit with a second doping level that is higher than a first doping level of the first material. Such a relatively higher second doping level may, for example, result in the second optical absorbance of the second layer 520 being greater than the first optical absorbance of the first layer 510, and the second laser ablation threshold of the second layer 520 being lower than the first laser ablation threshold of the first layer 510.

In an example implementation, the first material of the first layer 510 may comprise a low-nitrogen-doped n-type silicon carbide (SiC), and the second material of the second layer 520 may comprise a low-nitrogen-doped n-type silicon carbide (SiC) which has been heavily doped with carbon.

In an example implementation, the first material of the first layer 510 may comprise a low-doped gallium arsenide (GaAs), and block 220 may comprise growing (or forming) the second material of the second layer 520 to comprise heavily-doped gallium arsenide (GaAs). For example, block 220 may comprise forming the second material (e.g., GaAs, etc.) of the second layer 520 to be doped with an element of the VI group (e.g., selenium, etc.) to at least 5× 10¹⁷ cm³, at least 10¹⁸ cm³, to at least 5x 10¹⁸ cm³, to at least 10¹⁹ cm³, to any range between such levels, etc.

Also, in an example implementation, the second material of the second layer 520 may comprise a substantially different material than the first material of the first layer 510. For example, such first and second materials may be selected such that the second bandgap of the second material is narrower than the first bandgap of the first material. Such a narrower second bandgap may, for example, result in the second laser ablation threshold of the second layer 520 being less than the first laser ablation threshold of the first layer 510. Note that in such an example implementation, the second material of the second layer 520 may be lattice-matched to the first material of the first layer 510 (e.g., lattice-matched to within 5%, to within 7.5%, to within 10%, etc.).

In an example implementation involving III-IV compounds, the first material of the first layer 510 may comprise gallium arsenide (GaAs), and the second material of the second layer 520 may comprise indium arsenide (InAs). The lattice mismatch between the InAs and the GaAs may, for example, be about 7.2%.

The second layer 520 may be characterized by any of a variety of second thicknesses. For example, the second thickness of the second layer 520 may be up to 1 micron thick, may be up to 2 microns thick, may be up to 5 microns thick, may be up to 10 microns thick, may be a thickness in any range between such amounts, etc.

In general, block 220 (e.g., block 224, etc.) may comprise forming (e.g., growing, ion-implanting, etc.) the second layer 520 in any of a variety of manners. The scope of this disclosure should not be limited by characteristics of any particular manner of performing such forming.

Block 220 may, for example at block 226, comprise forming the third layer 530. Block 226 may, for example, comprising forming the third layer 530 utilizing any of the techniques (e.g., growing, depositing, mounting, etc.) discussed herein, for example with regard to the forming of the second portion 430-2 of the third layer 430 of Figure 4, with regard to the forming of the second layer 520 of Figure 5, etc.

The example third layer 530 may, for example, comprise a relatively high grade semiconductor material, for example of a quality used as a circuit layer during semiconductor circuitry production. For example, in an example implementation, before laser-splitting is performed (e.g., in the example method 900 of Figure 9), the third layer 530 may comprise semiconductor circuitry formed thereon. Note that the presence of such circuitry is not required. The third layer 530, however, is not limited to any particular type of material. For example, the third layer 530 may comprise a mid-grade or low-grade semiconductor material, a glass material, a ceramic material, a crystal material, etc.

The third layer 530 may, for example be characterized by a third laser ablation threshold. The third laser ablation threshold may, for example, be associated with a third level of laser energy at which the third material of the third layer 530 breaks down. The third laser ablation threshold may, for example, be associated with a third level of laser energy at which an ablation process occurs in the third material of the third layer 530. In an example configuration, the third laser ablation threshold may be higher than the second laser ablation threshold of the second layer 520.

For example, the third layer 530 may be characterized by a third optical transmittance (e.g., greater than the second optical transmittance, etc.), a third optical absorbance (e.g., less than the second optical absorbance, etc.), a third optical opacity (e.g., less than the second optical opacity, etc.), a third optical transparency (e.g., greater than the third optical transparency, etc.), etc. The third layer 530 may, for example, be characterized by a third bandgap (e.g., wider than the second bandgap, etc.).

As will be discussed in more detail here, in an example implementation, the third material of the third layer 530 may comprise the second material of the second layer 520, albeit with a third doping level that is lower than the second doping level of the second material. Such a relatively lower third doping level may, for example, result in the third optical absorbance being less than the second optical absorbance, the third laser ablation threshold being higher than the second laser ablation threshold, etc.

In an example implementation, the first material of the first layer 510 may comprise a low-nitrogen-doped n-type silicon carbide (SiC), and the second material of the second layer 520 may comprise a low-nitrogen-doped n-type silicon carbide (SiC) which has been heavily doped with carbon, and the third material of the third layer 530 may comprise a low-nitrogen-doped (or mid-nitrogen-doped) n-type silicon carbide (SiC). Note that in this example, the first doping level and the third doping level may be the same but may alternatively differ. For example, the third doping level may be greater than the first doping level and less than the second doping level.

In an example implementation, the first material of the first layer 510 may comprise a low-doped gallium arsenide (GaAs), the second material of the second layer 520 may comprise heavily-doped gallium arsenide (GaAs), and the third material of the third layer 530 may comprise low-doped (or mid-doped) gallium arsenide (GaAs). For example, the second material (e.g., GaAs, etc.) of the second layer 120 may be doped with an element of the VI group (e.g., selenium, etc.) to at least 5x 10¹⁷ cm³, to at least 10¹⁸ cm³, to at least 5x 10¹⁸ cm³, to at least 10¹⁹ cm³, to any range between such levels, etc. Note that in this example, the first doping level and the third doping level may be the same, but may alternatively differ. For example, the third doping level may be greater than the first doping level and less than the second doping level.

In an example implementation, the third material of the third layer 530 and the first material of the first layer 510 may correspond to similar or same materials, albeit having different respective quality levels. For example, the first material of the first layer 510 may correspond to a relatively low-quality material (e.g., a semiconductor material, a glass material, a ceramic material, a crystal material, etc.), and the third material of the third layer 530 may correspond to a relatively high-quality material (e.g., a semiconductor material, a glass material, a ceramic material, a crystal material, etc.).

Also, as will be discussed in more detail herein, in an example implementation, the third material of the third layer 530 may comprise a substantially different material than the second material of the second layer 520 and/or the first material of the first layer 510. For example, such third and second materials may be selected such that the third bandgap of the third material is wider than the second bandgap of the second material. Such a wider third bandgap may, for example, result in the third laser ablation threshold being greater than the second laser ablation threshold. Note that in such an example implementation, the third material of the third layer 530 may be lattice-matched to the second material of the second layer 520 (e.g., lattice-matched to within 5%, to within 7.5%, to within 10%, etc.).

In an example implementation involving III-IV compounds, the first material of the first layer 510 may comprise gallium arsenide (GaAs), the second material of the second layer 520 may comprise indium arsenide (InAs), and the third material of the third layer 130 may comprise gallium arsenide (GaAs). The lattice mismatch between the InAs and the GaAs may, for example, be about 7.2%. Note that the third material of the third layer 530 need not be the same as the first material of the first layer 510.

In another example implementation, the first material of the first layer 510 may comprise gallium arsenide (GaAs), the second material of the second layer 520 may comprise a relatively narrow bandgap layer of indium antimonide (InSb) which is lattice-matched to the GaAs of the first layer 510, and the third material of the third layer 530 comprises gallium indium phosphide (GaInP) which is lattice-matched to the InSb of the second layer 520.

In another example implementation, the second material of the second layer 520 may comprise gallium arsenide (GaAs), and the third material of the third layer 530 may comprise any of a variety of lattice-matching trinary-quaternary III-V compounds.

The third layer 530 may be characterized by any of a variety of third thicknesses. For example, the third thickness of the third layer 130 may be up to 1 micron thick, may be up to 2 microns thick, may be up to 5 microns thick, may be up to 10 microns thick, may be up to 25 microns thick, may be a thickness in any range between such amounts, etc.

As discussed herein, any combination of the example layer structures and/or example layer forming methods may be performed. Additional examples of such structure and/or method combinations will now be provided.

Figure 6 shows cross-sectional views illustrating an example laser-splittable structure and an example method for forming a laser-splittable structure, in accordance with various aspects of the present disclosure. Figure 6 and the example methods and structures shown therein will be discussed in conjunction with the flow diagram 200 of Figure 2.

Block 210 may comprise receiving an input structure. The example input structure 601 of Figure 6 provides an example of such a received input structure. Although the example input structure 601 is shown as having only one layer 610-1, the input structure 601 may comprise any number of layers. The received input structure 601 may, for example, share any or all characteristics with the example structure 100 of Figure 1 or any portion thereof. Also for example, the received input structure 601 and layer 610-1 thereof may share any or all characteristics with the example input structure 301 and layer 305 of Figure 3, with the example input structure 401 and layer 405 of Figure 4, with the example input structure 501 and layer 510 of Figure 5, etc.

Block 220 may comprise forming a laser-splittable structure. For example, block 220 may comprise forming an intermediate structure 602 and a laser-splittable structure 603.

The example intermediate structure 602 shown in Figure 6 may, for example, share any or all characteristics with the example structures 100, 302, 402, and 502 of Figures 1 and 3-5, or any portion thereof. For example, the layer 610-1, which may also be referred to herein as the first portion 610-1 of the first layer 610, may share any or all characteristics with the first layers 110, 310, 410, and 510 of Figures 1 and 3-5. Also for example, the intermediate layer 621 may share any or all characteristics with the first layers 110, 310, 410, and 510 of Figures 1 and 3-5, with the second layers 120, 320, 420, and 520 of Figures 1 and 3-5, and with the third layers 130, 330, 430, and 530 of Figures 1 and 3-5.

The example laser-splittable structure 603 shown in Figure 6 may, for example, share any or all characteristics with the example structures 100, 302, 402, 403, and 503 of Figures 1 and 3-5, or any portion thereof. For example, the first layer 610, for example comprising a first portion 610-1 and a second portion 610-2, may share any or all characteristics with the first layers 110, 310, 410, and 510 of Figures 1 and 3-5, the second layer 620 may share any or all characteristics with the second layers 120, 320, 420, and 520 of Figures 1 and 3-5, and/or the third layer 630 may share any or all characteristics with the third layers 130, 330, 430, and 530 of Figures 1 and 3-5.

Note that in the example implementation shown in Figure 6, the intermediate structure 602 may alternatively be viewed as the input structure received at block 210. For example, as discussed herein, the input structure received at block 210 may comprise any number of layers.

Block 220 may comprise forming the intermediate structure 602 in any of a variety of manners. For example, block 220 may comprise forming the intermediate structure 602 (e.g., the intermediate layer 621 thereof, etc.) in a same or similar manner to that discussed with regard to the forming of the second portion 430-2 of the third layer 430 of Figure 4, with regard to the forming of the second layer 520 and/or third layer 530 of Figure 5, etc.

For example, block 220 (e.g., at block 224) may comprising growing (or otherwise forming) the intermediate structure 602 (e.g., the intermediate layer 621 thereof, etc.) on (e.g., directly on, etc.) the layer 610-1, which may be viewed as a first portion 610-1 of the first layer 610.

Note that, in an example implementation, block 220 may comprise forming the intermediate structure 602 to have a thickness that is at least a desired thickness of the second layer 620 and the third layer 630. Also, in an example implementation, block 220 may forming the intermediate structure 602 to have a thickness that is at least a desired thickness of the second layer 620, the third layer 630, and the second portion 610-2 of the first layer 610.

After forming (or receiving) the intermediate structure 602, block 220 may comprise forming the second layer 620 and third layer 630. The forming of the second layer 620 and third layer 630 may also result in the forming (or defining) of the second portion 610-2 of the first layer 610.

Block 220 may comprise forming the second layer 620, the third layer 630, and the first layer 610 (e.g., comprising the first portion 610-1, the second portion 610-2, etc.) in any of a variety of manners, non-limiting aspects of which are provided herein.

For example, block 220 may comprising forming the second layer 620 and the third layer 630 in a same or similar manner to that disclosed and discussed herein with regard to Figure 3. For example, block 220 may comprise utilizing ion implantation to form the second layer 620 as a heavily doped layer within the intermediate layer 621. The third layer 630 may thus remain as a non-heavily doped layer on top of the second layer 620. Also, in an implementation in which the second layer 620 does not extend vertically to the bottom of the intermediate layer 621, a lower portion of the intermediate layer 621 may remain, which may be viewed as a second portion 610-2 of the first layer 610.

As discussed herein, for example with regard to Figures 3 and 4, it may be desirable to have a third layer 630 that is thicker than that resulting from the ion implantation process. As discussed herein, block 220 of the example method may comprise growing (or otherwise adding) material, for example a portion of a layer, an entirety of a layer, a plurality of layers, etc. Figure 7 provides examples of methods and structures similar to those of Figure 6, but with an additional material growing step.

Figure 7 shows cross-sectional views illustrating an example laser-splittable structure and an example method for forming a laser-splittable structure, in accordance with various aspects of the present disclosure. Figure 7 and the example methods and structures shown therein will be discussed in conjunction with the flow diagram 200 of Figure 2.

Block 210 may comprise receiving an input structure. The example input structure 701 of Figure 7 provides an example of such a received input structure. Although the example input structure 701 is shown as having only one layer 710-1, the input structure 701 may comprise any number of layers. The received input structure 701 may, for example, share any or all characteristics with the example structure 100 of Figure 1 or any portion thereof. Also for example, the received input structure 701 and layer 710-1 thereof may share any or all characteristics with the example input structure 301 and layer 305 of Figure 3, with the example input structure 401 and layer 405 of Figure 4, with the example input structure 501 and layer 510 of Figure 5, with the example input structure 601 and layer 610-1 of Figure 6, etc.

Block 220 may comprise forming a laser-splittable structure. For example, block 220 may comprise forming a first intermediate structure 702, a second intermediate structure 703, and a laser-splittable structure 704. Block 220 may comprise forming the laser-splittable structure in any of a variety of manners, non-limiting examples of which are provided herein.

The example first intermediate structure 702 shown in Figure 7 may, for example, share any or all characteristics with the intermediate structure 602 of Figure 6. For example, the first intermediate layer 721 may share any or all characteristics with the intermediate layer 621 of Figure 6.

The example second intermediate structure 703 shown in Figure 7 may, for example, share any or all characteristics with the laser-splittable structure 603 of Figure 6. For example, the second portion 710-2 of the first layer 710 may share any or all characteristics with the second portion 610-2 of the first layer 610 of Figure 6, the second layer 720 may share any or all characteristics with the second layer 620 of Figure 6, and the first portion 730-1 of the third layer 730 may share any or all characteristics with the third layer 630 of Figure 6. Note that the second intermediate structure 703 may also be viewed as a laser-splittable structure.

The example laser-splittable structure 704 shown in Figure 7 may, for example, share any or all characteristics with the example structures 100, 302, 402, 403, 503, and 603 of Figures 1 and 3-6, or any portion thereof. For example, the first layer 710, for example comprising a first portion 710-1 and a second portion 710-2, may share any or all characteristics with the first layers 110, 310, 410, 510, and 610 of Figures 1 and 3-6, the second layer 720 may share any or all characteristics with the second layers 120, 320, 420, 520, and 620 of Figures 1 and 3-6, and/or the third layer 730 may share any or all characteristics with the third layers 130, 330, 430, 530, and 630 of Figures 1 and 3-6.

Note that in the example implementation shown in Figure 7, the first intermediate structure 702 may alternatively be viewed as the input structure received at block 210. For example, as discussed herein, the input structure received at block 210 may comprise any number of layers.

Block 220 may, for example, comprising forming (or receiving) the input structure 701, the first intermediate structure 702, the second intermediate structure 703, and the laser-splittable structure 704 in any of a variety of manners. For example, the forming (or receiving) of the input structure 701, the first intermediate structure 702, and the second intermediate structure 703 may share any or all characteristics with the forming (or receiving) of the input structure 601, intermediate structure 602, and laser-splittable structure 603, respectively, discussed herein with regard to Figure 6.

Block 220 may, for example, comprise forming the laser-splittable structure 704 (e.g., from the second intermediate structure 703, etc.) in any of a variety of manners. For example, the forming of the laser-splittable structure 704 (e.g., from the second intermediate structure 703) may share any or all characteristics with the forming of the second portion 430-2 of the third layer 430 of Figure 4.

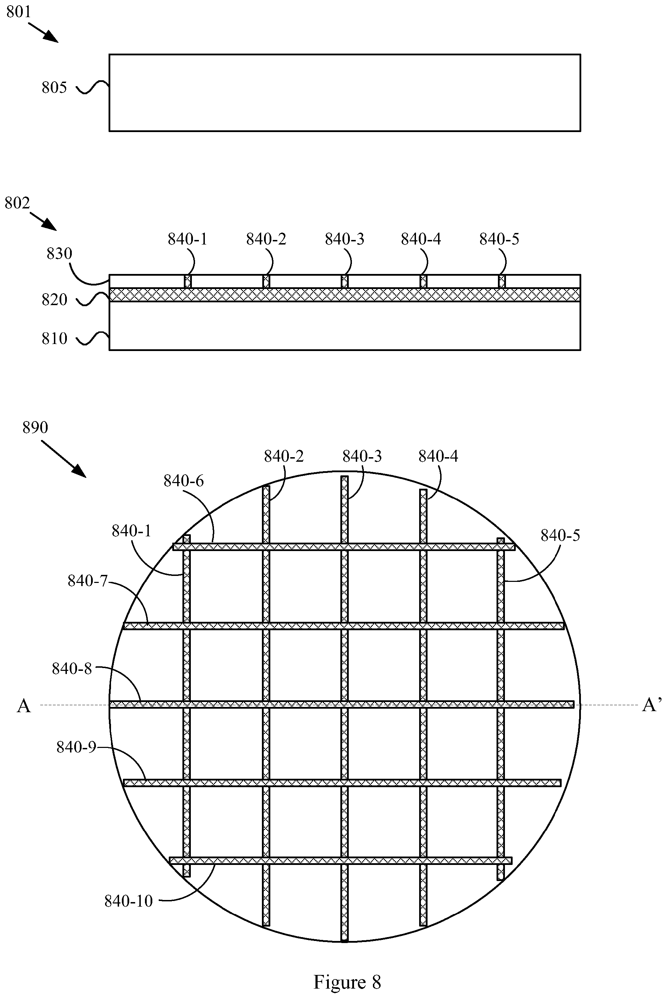

Various examples provided herein may comprise forming the second layer (e.g., the second layers 120, 320, 420, 520, 620, and 720 of Figures 1 and 3-7) as a planar layer, for example with a consistent (or substantially consistent) thickness. The present disclosure, however, is not limited to a planar configuration. For example, the second layer may be formed as a matrix of points or regions in the plane. Also for example, the second layer may comprise features that protrude from a generally planar shape. Such features may, for example, be utilized to define the structure to be laser split in a third dimension. In a semiconductor example, a second layer may be formed to split (or slice) a wafer from a thicker wafer or substrate, and may also be formed to dice the split wafer. Figure 8 provides an example of methods and structures comprising such aspects.

Figure 8 shows cross-sectional views illustrating an example laser-splittable structure and an example method for forming a laser-splittable structure, in accordance with various aspects of the present disclosure. Figure 8 and the example methods and structures shown therein will be discussed in conjunction with the flow diagram 200 of Figure 2.

Block 210 may comprise receiving an input structure. The example input structure 801 of Figure 8 provides an example of such a received input structure. Although the example input structure 801 is shown as having only one layer 805, the input structure 805 may comprise any number of layers. The received input structure 801 and layer 805 may, for example, share any or all characteristics with the example structure 100 of Figure 1 or any portion thereof (e.g., first layer 110, etc.). Also for example, the received input structure 801 and layer 805 may share any or all characteristics with the example input structure 301 and layer 305 of Figure 3. Additionally for example, the received input structure 801 and layer 805 may share any or all characteristics with the example input structure 401 and layer 405 of Figure 4, with the example input structure 501 and layer 510 of Figure 5, with the example input structure 601 and layer 610-1 of Figure 6, with the example input structure 701 and layer 710-1 of Figure 7, etc.

Block 220 may comprise forming a laser-splittable structure. Block 220 may comprise forming the laser-splittable structure in any of a variety of manners.

Figure 8 illustrates the laser-splittable structure in a top view at label 890 and illustrates a cross-sectional view 802 along line A-A'.

The example laser-splittable structure 802 may, for example, share any or all characteristics with the example laser-splittable structure 100 of Figure 1 or any portion thereof. Also for example, the example laser-splittable structure 802 may share any or all characteristics with the example laser-splittable structure 302 of Figure 3. For example, the first layer 810 may share any or all characteristics with the first layer 110 of Figure 1 and/or the first layer 310 of Figure 3, the second layer 820 may share any or all characteristics with the second layer 120 of Figure 1 and/or the second layer 320 of Figure 3, and the third layer 830 may share any or all characteristics with the third layer 130 of Figure 1 and/or the third layer 330 of Figure 3. The example laser-splittable structure 802 may, for example, share any or all characteristics with the example structures 100, 302, 402, 403, 503, 603, 703, and 704 of Figures 1 and 3-7, or any portion thereof.

Block 220 may, for example, comprise utilizing ion implantation to form at least the second layer 820 and/or third layer 830. Many examples of such forming are, for example, shown and discussed herein with regard to Figures 3, 4, 6, and 7, etc. Also for example, block 220 may comprise growing (or otherwise forming) the second layer 820 and/or third layer 830. Many examples of such forming are, for example, shown and discussed herein with regard to Figures 4, 5, 6, and 7, etc.

Block 220 may comprise utilizing ion implantation to form a third layer 830 with dicing lines 840-1 to 840-10.

The example third layer 830 may comprise dicing lines 840-1 to 840-10. Block 220 may comprise forming such dicing lines in any of a variety of manners. The dicing lines 840-1 to 840-10 may, for example, share any or all characteristics (e.g., laser ablation threshold, light absorption property, light transmissivity, doping level, etc.) with the second layer 820.

Block 220 may, for example, comprise utilizing ion implantation to form the dicing lines 840-1 to 840-10 within the third layer 830 before, during, or after ion implantation is used to form the second layer 820 and/or the third layer 830. Many examples of layers formed by ion implantation are provided herein, for example with regard to the forming of the layers 320, 420, 620, and 720 of Figures 3, 4, 6, and 7.

Also, block 220 may, for example, comprise utilizing ion implantation to form the dicing lines 840-1 to 840-10 after utilizing a process other than ion implantation (e.g., layer growing, etc.) to form the second layer 820 and/or the third layer 830. Many examples of layer growing are provided herein, for example with regard to the forming of the layers 430-2, 530, 621, and 721 of Figures 4-7. Many examples of layers formed by ion implantation are provided herein, for example with regard to the forming of the layers 320, 420, 620, and 720 of Figures 3, 4, 6, and 7.

Additionally, block 220 may, for example, comprise growing (or otherwise forming) the dicing lines 840-1 to 840-10. For example, block 220 may comprising growing (or otherwise forming) the dicing lines 840-1 to 840-10 before forming the bulk of the third layer 830, while forming the third layer 830, or after forming the bulk of the third layer 830. Many examples of layer growing are provided herein, for example with regard to the forming of the layers 430-2, 530, 621, 721 of Figures 4-7.

Note that the dicing lines 840-1 to 840-10 are non-limiting examples of three-dimensional features that might be incorporated in a material to enhance laser-splitting and/or laser-dicing.

Also note that the dicing lines (or other three-dimensional features) may be incorporated in any of the structures (e.g., input structures, intermediate structures, laser-splittable structures, etc.) or layers thereof discussed herein.

Various aspects of this disclosure disclose example methods and structures for laser splitting a structure, for example any or all of the laser-splittable structures provided herein (e.g., structures 100, 302, 402, 403, 503, 603, 703, 704, and 802 of Figures 1 and 3-8). Various additional examples of such methods and structures will now be provided.

Figure 9 shows a flow diagram illustrating an example method for laser splitting a structure, in accordance with various aspects of the present disclosure. The example method 900, for example any of the structures or layers formed thereby, may share any or all characteristics with the example methods and/or structures discussed herein with regard to Figures 1-8. Note that the scope of this disclosure is not limited to any particular order of the method blocks (or steps) discussed herein.

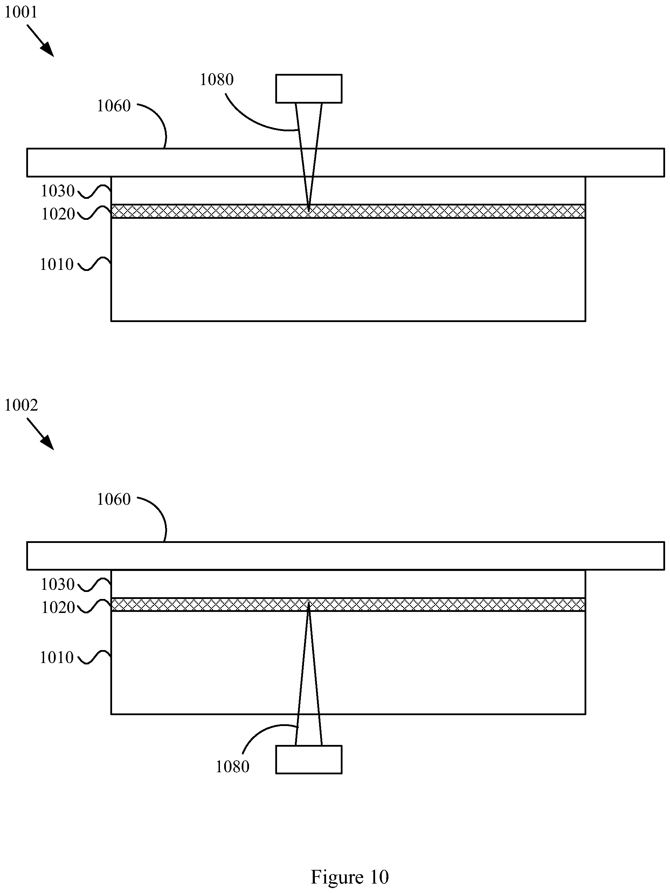

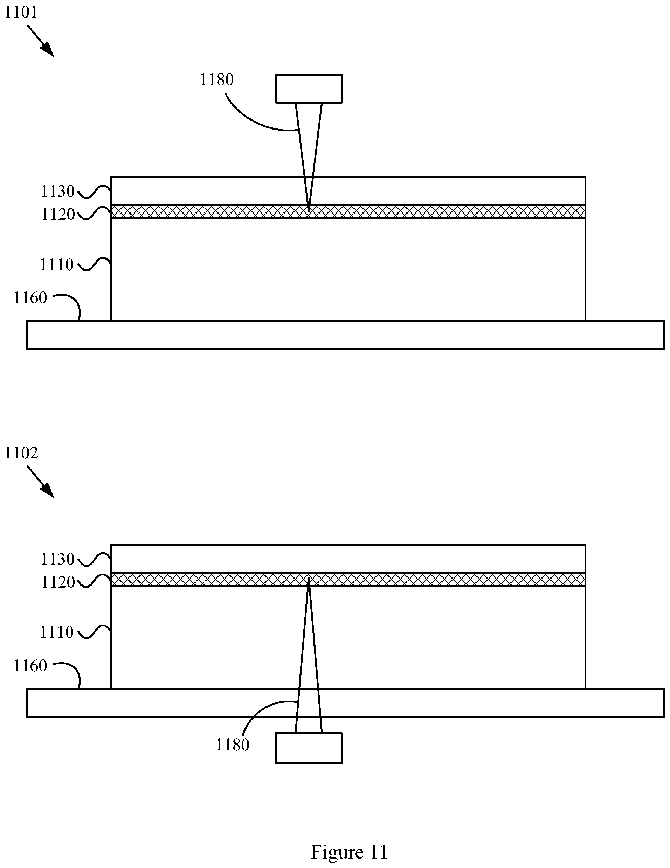

Figure 10 shows cross-sectional views 1001 and 1002 illustrating an example system for laser splitting a structure, an example laser-splittable structure, and an example method for laser splitting a structure, in accordance with various aspects of the present disclosure. Figure 11 shows cross-sectional views 1101 and 1102 illustrating an example system for laser splitting a structure, an example laser-splittable structure, and an example method for laser splitting a structure, in accordance with various aspects of the present disclosure. Figures 10 and 11 provide various illustrative examples of the methods and/or structures of Figure 9. Accordingly, Figures 9, 10, and 11 will be discussed together.

The structure (e.g., a laser-splittable structure) may, for example, comprise a first layer characterized by a first laser ablation threshold, a second layer characterized by a second laser ablation threshold, and a third layer characterized by a third laser ablation threshold. Note, however, that the laser-splittable structure may have any number of layers.

The example method 900 may begin executing at block 905. The method 900 may begin executing in response to any of a variety of causes or conditions, non-limiting examples of which are provided herein. For example, the method 900 may begin executing automatically in response to one or more signals received from one or more upstream and/or downstream manufacturing stations, in response to a signal from a central manufacturing line controller, etc. Also for example, the method 900 may begin executing in response to an operator command to begin.

The example method 900 may, at block 910, comprise receiving a structure to be laser split. Block 910 may comprise receiving the structure to be laser split, which may also be referred to herein as a laser-splittable structure in any of a variety of manners, non-limiting aspects of which are provided herein.

For example, block 910 may comprise receiving the laser-splittable structure from an upstream manufacturing process at a same premises, same campus, same site, etc. Also for example, block 910 may comprise receiving the laser-splittable structure from a shipping process. Note that the example method 900 may comprise forming the laser-splittable structure, for example prior to block 910, as a portion or all of block 910, etc.

The laser-splittable structure received at block 910 may comprise any of a variety of characteristics. For example, the received input structure may share any or all characteristics with the laser-splittable structures 100, 302, 402, 403, 503, 603, 703, 704, and 802 shown and discussed herein with regard to Figures 1-8.

Figure 10 shows an example laser-splittable structure comprising a first layer 1010, second layer 1020, and third layer 1030. The first layer 1010 may, for example, share any or all aspects with any of the first layers disclosed herein (e.g., first layer 110, 310, 410, 510, 610, 710, 810, etc.); the second layer 1020 may, for example, share any or all aspects with any of the second layers disclosed herein (e.g., second layer 120, 320, 420, 520, 620, 720, 820, etc.); and the third layer 1030 may, for example, share any or all aspects with any of the third layers disclosed herein (e.g., third layer 130, 330, 430, 530, 630, 730, 830, etc.).

Figure 11 shows an example laser-splittable structure comprising a first layer 1110, second layer 1120, and third layer 1130. The first layer 1110 may, for example, share any or all aspects with any of the first layers disclosed herein (e.g., first layer 110, 310, 410, 510, 610, 710, 810, etc.); the second layer 1120 may, for example, share any or all aspects with any of the second layers disclosed herein (e.g., second layer 120, 320, 420, 520, 620, 720, 820, etc.); and the third layer 1130 may, for example, share any or all aspects with any of the third layers disclosed herein (e.g., third layer 130, 330, 430, 530, 630, 730, 830, etc.).

In general, block 910 may comprise receiving a structure to be laser split. Accordingly, the scope of this disclosure should not be limited by characteristics of any particular manner of receiving a laser-splittable structure or by characteristics of any particular laser-splittable structure.

The example method 900 may, at block 920, comprise securing the received structure to be laser split. Block 920 may comprise securing the received structure to be laser split, also referred to herein as the laser-splittable structure, in any of a variety of manners, non-limiting examples of which are provided herein.

For example, block 920 may comprise coupling the laser-splittable structure to a carrier (or carrier substrate). The carrier may comprise any of a variety of characteristics. For example, the carrier may comprise a carrier wafer (or plate), for example comprising a semiconductor, glass, quartz, fused silica or sapphire, a ceramic, a crystal, a metal, etc.

Block 920 may, for example, comprise coupling the laser-splittable structure to the carrier in any of a variety of manners. For example, block 920 may comprise adhering the laser-splittable structure to the carrier, holding the laser-splittable structure to the carrier with a mechanical clamp or other fixture, utilizing vacuum pressure to hold the laser-splittable structure to the carrier, etc.

Figure 10 provides an example of a carrier 1060, to which the third layer 1030 of the laser-splittable structure is coupled. Figure 11 provides an example of a carrier 1160 to which the first layer 1110 of the laser-splittable structure is coupled.

In general, block 920 may comprise securing the received structure to be laser split. Accordingly, the scope of this disclosure is not limited by any particular manner or structure for performing such securing.

The example method 900 may, at block 930, comprise applying a laser to the laser-splittable structure (e.g., the laser-splittable structure received at block 910 and secured at block 920). Block 930 may comprising applying a laser to the laser-splittable structure in any of a variety of manners.

For example, block 930 may comprise utilizing any of a variety of types of lasers. For example, block 930 may comprise irradiating the laser-splittable structure with an Nd:YAGlaser, for example having a wavelength of about 1.064 microns. Block 930 may, for example, comprise irradiating the laser-splittable structure with a focused Nd:YAG laser with a 200 fs pulse duration, 200 nJ/pulse, and a 1 kHz repetition rate.

For example, block 930 may comprise focusing the laser on a particular layer of the laser-splittable structure. For example, 930 may comprise focusing the laser on a layer of the laser-splittable structure with a relatively low laser ablation threshold (or relatively high optical absorption, etc.). Non-limiting examples of such a layer are provided herein, for example the second layers 120, 320, 420, 520, 620, 720, 820, 1020, and 1120 of Figures 1, 3-8, 10, and 11.

As a result of the laser ablation, the layer on which the layer is focused (e.g., the second layer as discussed herein, any internal layer, etc.), or a substantial portion thereof, transforms into a layer of modified material containing amorphous residues, micro-voids and/or micro-cracks. Such a laser process may also, for example, be referred to as laser slicing, laser spitting, internal laser processing, internal ablation, laser exfoliation, stealth slicing, etc. For example, the laser may be focused on a very small (e.g., micron-sized, etc.) focal point. The optical power of the laser (e.g., a laser pulse, etc.) is absorbed within the focal point and its immediate surrounding.

When the laser power exceeds an ablation threshold (or laser ablation threshold) it triggers a chain of processes. These processes may, for example, comprise nonlinear, multi-photon absorption of the laser light, ionization of the material, the breaking of chemical bonds, the appearance of molecular fragments and residues, and the formation of micro-voids. In an example scenario of a silicon carbide (SiC) material, the internal ablation may lead to the breakage of the Si-C covalent bonds and the appearance of elemental silicon residue, elemental carbon residue, and micro-voids within the internal ablation in the SiC crystal bulk.

Block 930 may, for example, comprise scanning the laser across the target (e.g., the target layer, etc.) to produce a layer of such modified material. Such scanning may, for example, be performed in a continuous manner and/or at discrete points of the target (e.g., at a 2D and/or 3D matrix of points, etc.). The layer of modified material may, for example, be at a particular depth below the top surface of a laser-splittable structure. For example, in the examples provided herein, the laser may be focused on the second layer (e.g., the second layers 120, 320, 420, 520, 620, 720, 820, 1020, 1120 of Figures 1, 3-8, 10, and 11), transforming the second layer and/or select portions thereof into a layer of modified material comprising molecular fragments, residues, micro-voids, etc. In such a manner, block 930 may thus cause the second layer to be structurally weak and/or broken to serve as a plane of separation (or breaking point) between the first layer and the third layer.

Figure 10 shows example implementations in which the third layer 1030 of the laser-splittable structure (e.g., comprising the first layer 1010, second layer 1020, and third layer 1030) is coupled to the carrier 1060.

In the example implementation 1001, block 930 may comprise directing the laser beam 1080 through the carrier 1060 (e.g., a transparent carrier, a carrier made from material having substantially lower optical absorption than the second layer 1020, etc.), through the third layer 1030 (e.g., having a higher laser ablation threshold or lower optical absorption than the second layer 1020), and focused on the second layer 1020. For example, the vast majority of energy from the laser beam 1080 may be absorbed by (and act on) the second layer 1020.

In the example implementation 1002, block 930 may comprise directing the laser beam 1080 through the first layer 1010 (e.g., having a higher laser ablation threshold or lower optical absorption than the second layer 1020), and focused on the second layer 1020. For example, the vast majority of energy from the laser beam 1080 may be absorbed by (and act on) the second layer 1020.

Figure 11 shows example implementations in which the first layer 1130 of the laser-splittable structure (e.g., comprising the first layer 1110, second layer 1120, and third layer 1130) is coupled to the carrier 1160.

In the example implementation 1101, block 930 may comprise directing the laser beam 1180 through the third layer 1130 (e.g., having a higher laser ablation threshold or lower optical absorption than the second layer 1120), and focused on the second layer 1120. For example, the vast majority of energy from the laser beam 1180 may be absorbed by (and act on) the second layer 1120.

In the example implementation 1102, block 930 may comprise directing the laser beam 1180 through the carrier 1160 (e.g., a transparent carrier, a carrier made from material having substantially lower optical absorption than the second layer 1120, etc.), through the first layer 1110 (e.g., having a higher laser ablation threshold or lower optical absorption than the second layer 1120), and focused on the second layer 1120. For example, the vast majority of energy from the laser beam 1180 may be absorbed by (and act on) the second layer 1120.

Note that, block 930 may comprise applying a laser to the laser-splittable structure from multiple sides. For example, block 930 may comprising applying a laser as shown in example implementation 1001 and as shown in example implementation 1002. Also for example, block 930 may comprise applying a laser as shown in example implementation 1101 and as shown in example implementation 1102.

In general, block 930 may comprise applying a laser to the laser-splittable structure (e.g., the laser-splittable structure received at block 910 and secured at block 920). Accordingly, the scope of this disclosure is not limited by the characteristics of particular examples provided herein.

The example method 900 may, at block 940, comprise separating the parts of the structure (e.g., the laser-splittable structure to which the laser was applied at block 930). Block 940 may comprise performing such separation in any of a variety of manners. Note that such separation may also be referred to herein as split activation.

Block 940 may, for example, comprise pulling the third layer (e.g., the third layers 130, 330, 430, 530, 630, 730, 830, 1030, 1130 of Figures 1, 3-8, 10, and 11, etc.) from the first layer (e.g., the first layers 110, 310, 410, 510, 610, 710, 810, 1010, 1110 of Figures 1, 3-8, 10, and 11, etc.). Block 940 may, for example, comprise performing the separation utilizing a mechanical technique (e.g., pulling, sheering, vibrating, impulse shocking, etc.), a thermal technique (e.g., thermal expansion and/or expansion, etc.), and/or a sound-based technique, etc.

Block 940 may, for example, cause the propagation and interconnection of micro-cracks (e.g., formed at block 930), ultimately leading to the separation of the layers (e.g., separation of the third layer from the first layer). Note that in an example scenario in which the internal ablation of the second layer is complete, no additional mechanical and/or thermal forces need be utilized.

In general, block 940 may comprise separating the parts of the structure. Accordingly, the scope of this disclosure should not be limited by characteristics of any particular manner of performing such separating.

The example method 900 may, at block 995, comprise performing continued processing. Block 995 may comprise performing any of a variety of types of continued processing.

For example, block 995 may comprise directing execution flow of the example method 900 to any other block. Block 995 may, for example, comprise coupling the separated third layer to a handle substrate for further processing. Such a handle substrate may, in various example implementations, be utilized as a contact (e.g., a drain contact, etc.), ground, and/or heat sink of a packaged device.

Also for example, block 995 may comprise cleaning the separated layers (e.g., the first layer, the third layer, etc.). For example, in an example implementation, block 930 and/or block 940 may result in residual material (e.g., from the second layer, etc.) left on the first layer and/or on the third layer. In such an example implementation, such residual material may be left or may be removed (e.g., by etching, by chemical/mechanical polishing, by grinding, etc.).

Block 995 may additionally, for example, comprise dicing one or more layers separated at block 940. For example, in a semiconductor wafer example, block 995 may comprise dicing a semiconductor wafer layer that was separated from a substrate layer at block 940. Block 995 may also, for example, comprise packaging and/or shipping one or more layers separated at block 940.

Block 995 may further, for example, comprise preparing one or more layers separated at block 940 for reuse. For example, in an example scenario in which the first layer is a substrate, block 995 may comprise preparing such a substrate for reuse, for example cleaning, smoothing, inspecting, testing, etc.

In general, block 995 may comprise performing continued processing. Accordingly, the scope of this disclosure should not be limited by characteristics of any particular type of continued processing.

Note that although the various examples of this disclosure are presented in the context of laser splitting, the scope of this disclosure is not limited thereto. For example, a focused light other than laser may be utilized. Also for example, other forms of energy (e.g., RF energy, plasma energy, etc.) may be utilized to perform the splitting.

The discussion herein included numerous illustrative figures that showed various portions of laser-splittable structures and/or methods of manufacturing thereof, laser-splitting systems and/or methods for performing laser splitting, etc. Such structures, systems, and/or methods are merely examples and do not limit the scope of this disclosure.

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:
1. A method of laser-splitting a structure, the method comprising:
   receiving the structure, where the structure comprises:
   a first layer, where the first layer is characterized by a first laser ablation threshold;
   a second layer, where the second layer is characterized by a second laser ablation threshold that is less than the first laser ablation threshold; and
   a third layer, where the second layer is between the first layer and the third layer; and splitting the material structure by, at least in part, applying a laser to the second layer.
2. The method of aspect 1, where the third layer is characterized by a third laser ablation threshold that is greater than the second laser ablation threshold.
3. The method of aspect 1, wherein:
   the first layer is characterized by a first doping level; and
   the second layer is characterized by a second doping level that is greater than the first doping level.
4. The method of aspect 1, wherein:
   the first layer is characterized by a first bandgap; and
   the second layer is characterized by a second bandgap that is narrower than the first bandgap.
5. The method of aspect 1, comprising forming the second layer, where said forming the second layer comprises performing ion implantation.
6. The method of aspect 1, comprising forming the second layer, where said forming the second layer comprises growing the second layer.
7. The method of aspect 1, wherein said splitting the material structure comprises, after applying the laser to the second layer, performing split activation.
8. The method of aspect 1, wherein said applying the laser to the second layer comprises:
   focusing the laser on the second layer; and
   transmitting the laser to the second layer through the first layer and/or the third layer.
9. The method of aspect 1, wherein the material structure comprises a semiconductor wafer.
10. A method of forming a laser-splittable structure, the material structure comprising a first layer characterized by a first laser ablation threshold, a second layer characterized by a second laser ablation threshold, and a third layer characterized by a third laser ablation threshold, the method comprising:
   receiving an input structure, where the input structure comprises at least a portion of the first layer; and
   forming the second layer, where the second layer is characterized by a second laser ablation threshold that is less than the first laser ablation threshold, and the second layer is between the first layer and the third layer.
11. The method of aspect 10, wherein the second laser ablation threshold is less than the third laser ablation threshold.
12. The method of aspect 10, wherein said forming the second layer comprises utilizing ion implantation to increase an optical absorption characteristic of the second layer.
13. The method of aspect 10, wherein said forming the second layer comprises growing the second layer on the first layer.
14. The method of aspect 13, wherein said growing the second layer on the first layer comprises growing the second layer to have a higher level of doping than the first layer.
15. The method of aspect 13, wherein said growing the second layer on the first layer comprises growing the second layer to have a narrower bandgap than the first layer.
16. The method of aspect 10, wherein the input structure comprises a semiconductor wafer.
17. The method of aspect 10, wherein:
   the first layer comprises bulk semiconductor material; and
   the third layer comprises semiconductor circuitry.
18. The method of aspect 10, comprising forming the third layer on the second layer by growing at least a portion of the third layer on the second layer.
19. A structure for laser splitting, the structure comprising:
   a first layer, where the first layer is characterized by a first laser ablation threshold;
   a second layer, where the second layer is characterized by a second laser ablation threshold that is less than the first laser ablation threshold; and
   a third layer, where the third layer is characterized by a third laser ablation threshold that is greater than the second laser ablation threshold and the second layer is between the first layer and the third layer.
20. The material structure of aspect 19, wherein:
   the first layer is characterized by a first doping level; and
   the second layer is characterized by a second doping level that is greater than the first doping level.
21. The material structure of aspect 19, wherein:
   the first layer is characterized by a first bandgap; and
   the second layer is characterized by a second bandgap that is narrower than the first bandgap.

Implementations as described herein may relate to the following: A laser-splittable structures (for example, semiconductor wafers), methods for making a laser-splittable structure, systems for laser splitting a structure, and methods for laser splitting a structure. As non-limiting examples, various aspects of this disclosure provide laser-splittable semiconductor wafers, laser-splittable structures (for example, semiconductor wafers), methods for making a laser-splittable structure, systems for laser splitting a structure, and methods for laser splitting a structure, where the laser-splittable structure comprises a first layer characterized by a first laser ablation threshold, and a second layer characterized by a second laser ablation threshold that is less than the first laser ablation threshold.

The present application claims priority of U.S. Patent Application No. 18/418,966, filed January 22, 2024. The entire disclosure of this application is hereby explicitly incorporated by reference into the present application.

In summary, various aspects of this disclosure provide laser-splittable structures (for example, semiconductor wafers), methods for making a laser-splittable structure, systems for laser splitting a structure, and methods for laser splitting a structure. While the foregoing has been described with reference to certain aspects and examples, it will be understood by those skilled in the art that various changes may be made and equivalents may be substituted without departing from the scope of the disclosure. In addition, many modifications may be made to adapt a particular situation or material to the teachings of the disclosure without departing from its scope. Therefore, it is intended that the disclosure not be limited to the particular example(s) disclosed, but that the disclosure will include all examples falling within the scope of the appended claims.

## Claims

1. A method of laser-splitting a structure, the method comprising:
receiving the structure, where the structure comprises:
a first layer, where the first layer is **characterized by** a first laser ablation threshold;
a second layer, where the second layer is **characterized by** a second laser ablation threshold that is less than the first laser ablation threshold; and
a third layer, where the second layer is between the first layer and the third layer; and splitting the structure by, at least in part, applying a laser to the second layer.

2. The method of claim 1, where the third layer is **characterized by** a third laser ablation threshold that is greater than the second laser ablation threshold.

3. The method of claim 1 or 2, wherein:
a) the first layer is **characterized by** a first doping level; and
the second layer is **characterized by** a second doping level that is greater than the first doping level, and/or
b) the first layer is **characterized by** a first bandgap; and
the second layer is **characterized by** a second bandgap that is narrower than the first bandgap.

4. The method of any one of claims 1 to 3, comprising:
a) forming the second layer, where said forming the second layer comprises performing ion implantation, and/or
b) forming the second layer, where said forming the second layer comprises growing the second layer.

5. The method of any one of claims 1 to 4, wherein said splitting the structure comprises, after applying the laser to the second layer, performing split activation.

6. The method of any one of claims 1 to 5, wherein said applying the laser to the second layer comprises:
focusing the laser on the second layer; and
transmitting the laser to the second layer through the first layer and/or the third layer.

7. The method of any one of claims 1 to 6, wherein the structure comprises a semiconductor wafer.

8. A method of forming a laser-splittable structure, the structure comprising a first layer **characterized by** a first laser ablation threshold, a second layer **characterized by** a second laser ablation threshold, and a third layer **characterized by** a third laser ablation threshold, the method comprising:
receiving an input structure, where the input structure comprises at least a portion of the first layer; and
forming the second layer, where the second layer is **characterized by** a second laser ablation threshold that is less than the first laser ablation threshold, and the second layer is between the first layer and the third layer.

9. The method of claim 8, wherein the second laser ablation threshold is less than the third laser ablation threshold.

10. The method of claim 8 or 9, wherein said forming the second layer comprises:
a) utilizing ion implantation to increase an optical absorption characteristic of the second layer, and/or
b) growing the second layer on the first layer.

11. The method of claim 10, option b), wherein said growing the second layer on the first layer comprises
a) growing the second layer to have a higher level of doping than the first layer, and/or
b) growing the second layer to have a narrower bandgap than the first layer.

12. The method of any one of claims 8 to 11, wherein the input structure comprises a semiconductor wafer.

13. The method of any one of claims 8 to 12, wherein:
the first layer comprises bulk semiconductor material; and
the third layer comprises semiconductor circuitry.

14. The method of any one of claims 8 to 13, comprising forming the third layer on the second layer by growing at least a portion of the third layer on the second layer.

15. A structure for laser splitting, the structure comprising:
a first layer, where the first layer is **characterized by** a first laser ablation threshold;
a second layer, where the second layer is **characterized by** a second laser ablation threshold that is less than the first laser ablation threshold; and
a third layer, where the third layer is **characterized by** a third laser ablation threshold that is greater than the second laser ablation threshold and the second layer is between the first layer and the third layer, and optionally wherein
a) the first layer is **characterized by** a first doping level; and
the second layer is **characterized by** a second doping level that is greater than the first doping level, and/or
b) the first layer is **characterized by** a first bandgap; and
the second layer is **characterized by** a second bandgap that is narrower than the first bandgap.
